# EUROPEAN PATENT SPECIFICATION

(11) **EP 1 273 212 B1**
(45) Date of publication and mention of the grant of the patent: **21.06.2006**
(21) Application number: 01923208.1
(22) Date of filing: 05.04.2001
(51) Int. Cl.: H05K 3/00, H05K 3/42

(54) **DOUBLE-SIDED WIRING BOARD AND ITS MANUFACTURE METHOD**
DOPPELSEITIGE LEITERPLATTE UND VERFAHREN ZU DEREN HERSTELLUNG
TABLEAU DE CONNEXION DOUBLE FACE ET SON PROCEDE DE FABRICATION

(30) Priority: 14.04.2000 JP 2000113688
(43) Date of publication of application: 08.01.2003
(73) Proprietor: 3M Innovative Properties Company, St. Paul, MN 55133-3427 (US)
(72) Inventor: KOYANAGI, Tatsunori, Saint Paul, MN 55133-3427 (US); SAITO, Yusuke, Saint Paul, MN 55133-3427 (US); YASUI, Hideaki, Saint Paul, MN 55133-3427 (US)
(74) Representative: Hilleringmann, Jochen
(86) International application number: PCT/US2001/011323
(87) International publication number: WO 2001/080609

(56) References cited:
- RAY S K: "Pulsed laser generation of vias in thin polyimide layers" IBM TECHNICAL DISCLOSURE BULLETIN, IBM CORP. NEW YORK, US, vol. 26, no. 7B, December 1983 (1983-12), pages 3586-3587, XP002157888 ISSN: 0018-8689
- PATENT ABSTRACTS OF JAPAN vol. 1999, no. 14, 22 December 1999 (1999-12-22) & JP 11 266068 A (CANON INC), 28 September 1999 (1999-09-28)
- PATENT ABSTRACTS OF JAPAN vol. 017, no. 356 (E-1394), 6 July 1993 (1993-07-06) & JP 05 055724 A (HITACHI SEIKO LTD), 5 March 1993 (1993-03-05)
- "LASER ABLATION OF THIN CHROMIUM LAYER" RESEARCH DISCLOSURE, KENNETH MASON PUBLICATIONS, HAMPSHIRE, GB, no. 292, 1 August 1988 (1988-08-01), page 617 XP000111669 ISSN: 0374-4353
- "PROCESSES FOR MANUFACTURING MULTILAYER TAB" RESEARCH DISCLOSURE, KENNETH MASON PUBLICATIONS, HAMPSHIRE, GB, no. 373, 1 May 1995 (1995-05-01), pages 303-307, XP000518622 ISSN: 0374-4353
- "COMBINED LASER PROCESSING OF VIAS AND CIRCUITRY IN FLEX-CIRCUITS" IBM TECHNICAL DISCLOSURE BULLETIN, IBM CORP. NEW YORK, US, vol. 38, no. 5, 1 May 1995 (1995-05-01), pages 607-608, XP000519699 ISSN: 0018-8689
- PATENT ABSTRACTS OF JAPAN vol. 1999, no. 12, 29 October 1999 (1999-10-29) & JP 11 186678 A (MITSUBISHI ELECTRIC CORP), 9 July 1999 (1999-07-09)
- PATENT ABSTRACTS OF JAPAN vol. 2000, no. 02, 29 February 2000 (2000-02-29) & JP 11 300487 A (SONY CORP), 2 November 1999 (1999-11-02)
- "MODELLING THE SURFACE OF AN ADHESION-PROMOTING FILM BY LASER IRRADIATION WITHOUT A MASK" IBM TECHNICAL DISCLOSURE BULLETIN, IBM CORP. NEW YORK, US, vol. 32, no. 3B, 1 August 1989 (1989-08-01), pages 437-439, XP000029782 ISSN: 0018-8689

## Description

### DETAILED DESCRIPTION OF THE INVENTION

The present invention relates to a double-sided wiring board in which a wiring layer consisting of a conductor of copper or the like is formed on each face of an insulator of a polyimide film or the like, and both wiring layers are electrically connected, e.g., through a blind via hole, and a method for manufacturing the double-sided wiring board.

In one way to increase a wiring density at a wiring board such as a printed wiring board or the like, both faces of a sheet-like insulator which becomes the wiring board are wired and an electric connection is provided between the wirings. In another way, this type of double-sided wiring board is layered with a plurality of like boards, thereby forming a multilayer wiring board. The double-sided wiring board is manufactured, for example, as described hereinbelow.

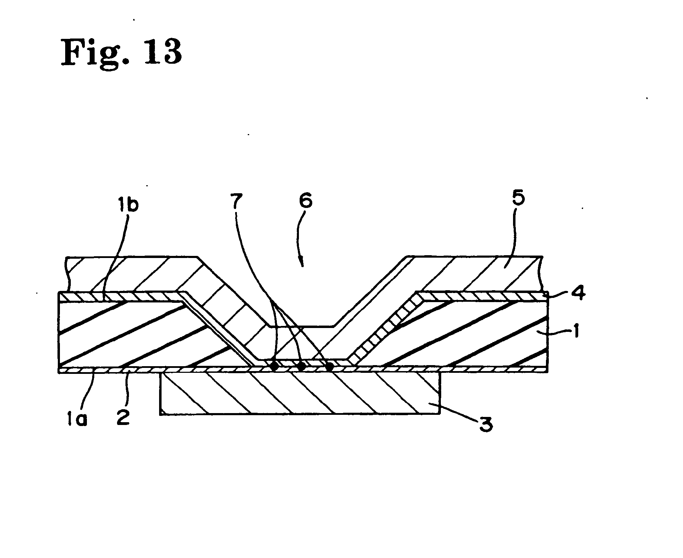

Referring to Fig. 13 showing a conventional double-sided wiring board, an interfacial layer 2 of.Cr, Ni or the like is formed on a first face la of a film-shaped insulator 1 of polyimide or the like by sputtering or vapor deposition, and then a wiring layer 3 of a conductor of copper or the like is formed on the interfacial layer 2 by sputtering and plating. In comparison with the case where the wiring layer 3 is directly formed to the insulator 1, the presence of the interfacial layer 2 increases an adhesion of the wiring layer 3 to the insulator 1.

The wiring layer 3 is patterned to the first face 1a by an additive method or subtractive method. Thereafter, a second face 1b of the insulator 1 opposite to the first face 1a is selectively etched, whereby a recessed via hole part blocked by the wiring layer 3 is formed. After the via hole part is subjected to a cleaning treatment, an interfacial layer 4 of Cr, Ni or the like is formed to the second face 1b by sputtering or vapor deposition, on which a wiring layer 5 of a conductor of, for instance, copper is formed by sputtering and plating.

According to the above procedures, also the recessed part formed at the side of the second face 1b of the insulator 1 is equipped with the interfacial layer 4 and wiring layer 5 as illustrated in the drawing, thus realizing an electric connection between the wiring layers 3 and 5. The above via hole part becomes a blind via hole 6. The blind via hole means a hole which one of openings at both ends of this hole is blocked.

In the event that the cleaning treatment is insuffciently carried out, or the interfacial layer 4 of Cr, Ni or the like is arranged to the second face 1b, or a foreign matter 7 mixes, the reliability of the junction between the wiring layers 5 and 3 might be adversely influenced at the blind via hole 6.

Lately, the via hole parts are made increasingly smaller in diameter as a consequence of the integration of semiconductor elements in higher densities. In other words, in some cases, a cleaning treatment is impossible in a wet process or it is impossible to clean the interior of the blind via hole 6 of a minute diameter. Generally, a via hole diameter that enables the via hole to be formed by etching and enables the via hole to be cleaned in the wet process is approximately equal to a thickness of the insulator 1. For example, if the cleaning treatment is insufficient, the foreign matter 7 such as broken pieces of the insulator 1 or the like is found between the interfacial layer 2 formed on the first face 1a and the interfacial layer 4 formed on the second face 1b. As a result, the reliability of the connection of the wiring layers 3 and 5 at the blind via hole 6 is greatly affected.

PATENT ABSTRACTS OF JAPAN vol. 1999, no. 14, 22 December 1999 (1999-12-22) & JP 11 266068 A (CANON INC), 28 September 1999 (1999-09-28) discloses a method for manufacturing a double-sided wiring board comprising the steps of forming a first interfacial layer, forming a first wiring layer, forming a recess in an insulator opened to the second face, wherein the first interfacial layer and the first wiring layer are used as a blockage material, irradiating a laser light from a side of the second face to a blockage part of the recess so as to remove the first interfacial layer at the blockage part to expose the first wiring layer, and forming a second wiring layer of a conductor on the blockage part of the recess wherein the second wiring layer within the blockage part being united on the first wiring layer and electrically connected thereto.

Moreover, RAY S K: 'Pulsed laser generation of vias in thin polyimide layers' IBM TECHNICAL DISCLOSURE BULLETIN, IBM CORP. NEW YORK, US, vol. 26, no. 7B, December 1983 (1983-12), pages 3586-3587, XP002157888 ISSN: 0018-8689, discloses a method for pulsed laser generation of vias and discloses partial removal of metal by laser beam to improve adhesion of subsequently deposited metal.

Finally, PATENT ABSTRACTS OF JAPAN vol. 017, no. 356 (E-1394), 6 July 1993 (1993-07-06) & JP 05 055724 A (HITACHI SEIKO LTD), 5 March 1993 (1993-03-05) relates to formation of holes in a printed circuit board by use of laser and discloses cleaning of the bottom of the hole by laser beam to improve adhesion.

One object of the present invention is to provide a double-sided wiring board in which an electric connection between two wiring layers is obtained with the use of a recess, thereby being improved in reliability on electric connection as compared with the related art, and a method for manufacturing the double-sided wiring board.

### SUMMARY OF THE INVENTION

In order to accomplish the above objective by the present invention a method according to claim 1 and a double-sided wiring board according to claim 3 are provided.

The invention will be described hereinbelow in more detail referring to the drawings in which :

### BRIEF DESCRIPTION OF THE DRAWINGS

Fig. 1 is a diagram descriptive of a state when a laser light is irradiated to a blockage part in a manufacture process for a double-sided wiring board according to an embodiment of the present invention.
Fig. 2 is a sectional view of the double-sided wiring board in the embodiment of the present invention.
Fig. 3 is a diagram of a state when a first interfacial layer is formed in the manufacture process for the double-sided wiring board in the embodiment of the present invention.
Fig. 4 is a diagram of a state when a first wiring layer is formed on the first interfacial layer of Fig. 3.
Fig. 5 is a diagram of a state when a recess to be used as a blind via hole part is formed to the board shown in Fig. 4.
Fig. 6 is a diagram of a state in which a second interfacial layer and the first interfacial layer are removed through the irradiation of the laser light to a blockage part of the blind via hole part.

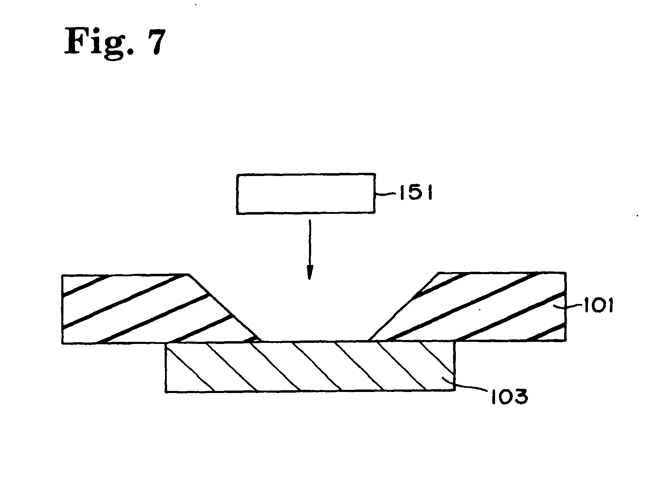

Fig. 7 is a diagram of a state in which the laser light is directly irradiated to the first wiring layer according to a modified example of the manufacture process for the double-sided wiring board of the embodiment of the present invention.
Fig. 8 shows the constitution of a laser light apparatus.
Fig. 9 is a table of an irradiation condition of the laser light.
Fig. 10 is a diagram of a modified example showing a shape of the blockage part to which the laser light is irradiated and a shape of an exposed face.
Fig. 11 is a diagram of a different modified example showing shapes of the blockage part to which the laser light is irradiated and the exposed face.
Fig. 12 is a diagram of a modification of the double-sided wiring board shown in Fig. 2.
Fig. 13 is a sectional view of a conventional double-sided wiring board.

### DETAILED DESCRIPTION OF THE INVENTION

A double-sided wiring board in an embodiment of the present invention, and a method for manufacturing the double-sided wiring board will be described hereinbelow with reference to the drawings in which the same parts are designated by the same reference numerals.

In the present embodiment, the double-sided wiring board is, by way of example, a substrate having conductive layers formed on both faces of one insulator. The present invention is not restricted to this type of substrate and is applicable similarly to a multilayer double-sided wiring board having a plurality of insulators each having conductive layers on both faces.

On the other hand, a blind via hole part is depicted as an example of a function of the "recessed part" according to the present embodiment. However, the present invention is not limited to the blind via hole part and is applicable to any substrates wherein the recessed part is blocked at a side of a first face and opened to a second face of the insulator having the first and second faces opposite to each other.

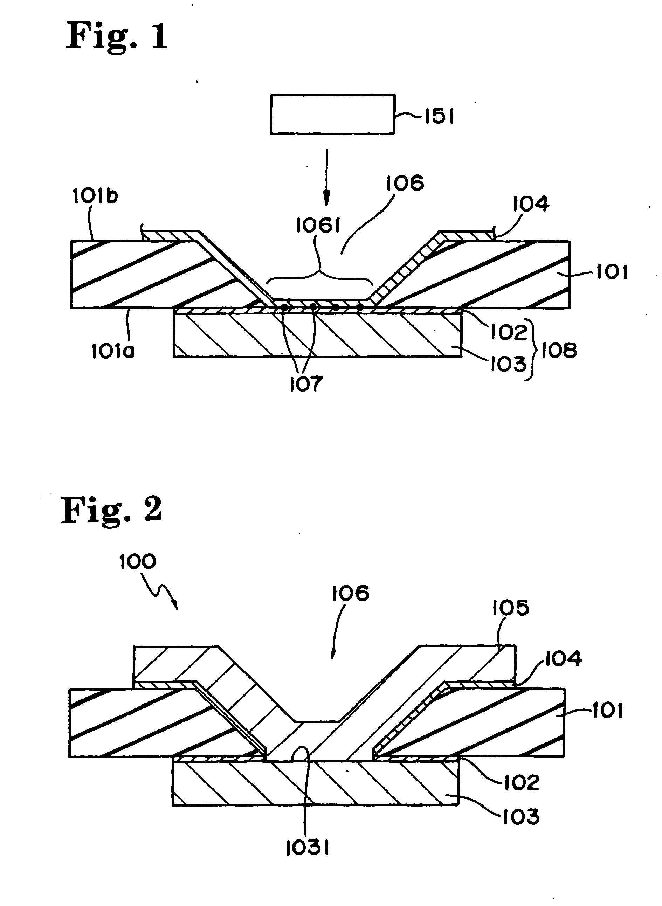

The double-sided wiring board of the embodiment will be schematically described with reference to the drawings. As shown in Fig. 1, a blind via hole part, 106 is formed with an opening opened at a second face 101 b of an insulator 101 which has a first face 101 a and the second face 101 b opposite to the first face. A laser light is irradiated to a blockage part 1061 of the blind via hole part 106 by a laser apparatus 151 from the side of the second face 101b. By the irradiation of the laser light, a foreign matter 107 present at the blockage part 1061 is removed and a first wiring layer 103 of a conductor set on the first face 101a is exposed. A second wiring layer 105 is formed to an exposed face 1031 of the exposed first wiring layer 103. The second wiring layer is a conductor united to the exposed face 1031 and electrically connected to the first wiring layer 103 as shown in Fig. 2.

For instance, published specifications of Unexamined Japanese Patent Laid-Open Publication No. 10-12987 and U.S.-A-5,567,329 and US-A-5,906,043 reveal a technique of electrically connecting wiring layers formed to both faces of an insulator with use of a blind via hole part of a substrate. The technique disclosed in the published specification No. 10-12987 provides an electric connection for the wiring layers by a solder, without describing nor suggesting the removal of the foreign matter by the irradiation of laser light as conducted in the present embodiment. Likewise, U.S. -A-5,567,329 depicts the technique of electrically connecting wiring layers by a plurality of via holes, but does not describe, nor gives a hint on the removal of the foreign matter by the irradiation of laser light as in the present embodiment. Neither U.S.-A-5,906,043 discloses, suggests the elimination of the foreign matter by means of the irradiated laser light.

A manufacture process for the double-side wiring board of the embodiment will be detailed below.

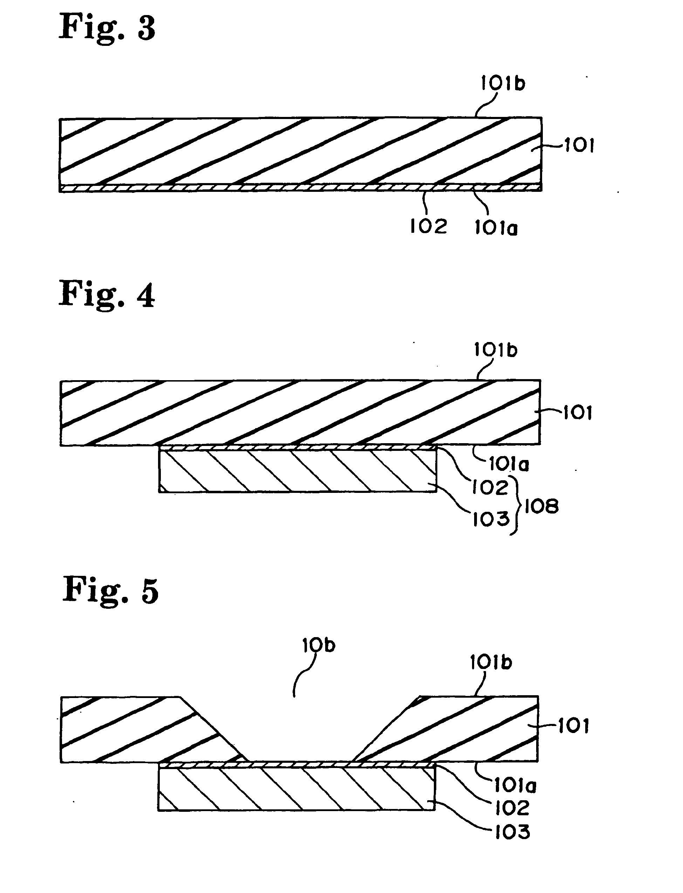

Referring to Fig. 3, Cr, Ni, Zn, Co or the like is formed singly or by a composite on the first face 101 a of the insulator 101 1 of, e.g., polyimide by a dry plating method, for example, sputtering or vapor deposition into a thickness of 10-500nm, preferably 150nm. A first interfacial layer 102 is formed then in a thickness of approximately 5 µm by an electroplating method. Similar to the earlier described related art, the first interfacial layer 102 and a second interfacial layer 104 which will be depicted later act to increase an adhesion of wiring layers to the insulator 101 as compared with the case where the wiring layers are directly formed on the insulator 101. In Fig.3, the first interfacial layer 102 is formed on a part of the first face 101a to meet a first wiring layer 103 which will be described later, but the embodiment is not limited to this arrangement.

Thereafter, in Fig. 4, a conductor of metal or the like, specifically, the first wiring layer 103 of copper according to the embodiment is formed into a thickness of approximately 15-50µm on the first interfacial layer 102 by electroplating. An unnecessary part is removed by etching or the like manner, so that the first wiring layer 103 of a predetermined pattern is formed.

The above first interfacial layer 102 and the first wiring layer 103 constitute a first conductive layer 108.

Next, as shown in Fig. 5, the blind via hole part 106 opened to the second face 101b is formed in the insulator 101 with using the first interfacial layer 102 and the first wiring layer 103 as a blockage material.

Back to Fig. 1, the second interfacial layer 104 is formed on the second face 101 b in a thickness of about 5µm in the same manner as the first interfacial layer 102. At this time, the second interfacial layer 104 is formed also onto the first interfacial layer 102 at the blockage part 1061 of the blind via hole part 106 as is apparent in the drawing.

The foreign matter 107, such as debris from the insulator 101, oxide or the like, may be found between the first interfacial layer 102 at the blockage part 1061 and the second interfacial layer 104 when the second interfacial layer 104 is formed, as referred to in the related art. Moreover, the cleaning treatment prior to the formation of the second interfacial layer 104 is possibly insufficient because a diameter of the blind via hole part 106 is minute when the blockage part 1061 has a diameter of approximately 100-300µm. In such circumstances, the debris of the insulator 101 and the like may be left unremoved at the blockage part 1061, the same as in the related art.

Meanwhile, the above blockage part 1061 is irradiated by the laser light from the laser apparatus 151 according to the present embodiment, thereby removing the second interfacial layer 104 and the first interfacial layer 102, which also possibly includes the foreign matter 107, debris or the like. As mentioned above, each of the second interfacial layer 104 and the first interfacial layer 102 has the thickness of approximately 5 µm, and eventually the laser light may remove nearly 10µm of the interfacial layers. Preferably, not only the second interfacial layer 104 and the first interfacial layer 102, but the first wiring layer 103 present immediately below the first interfacial layer 102 is removed by the laser light to a depth of approximately 5µm together with the second interfacial layer 104 and first interfacial layer 102 to form a recess.

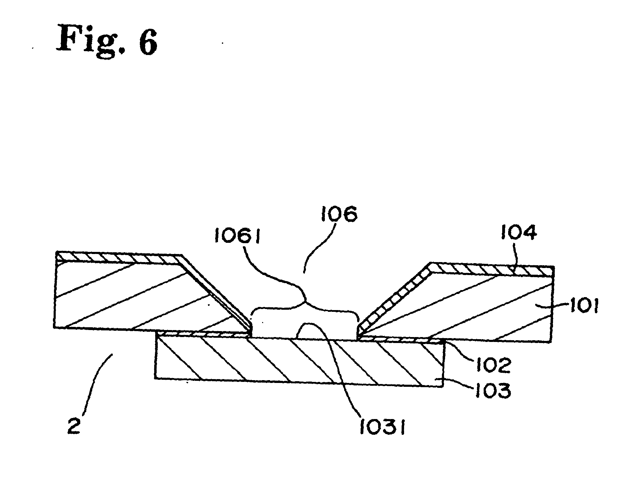

Through the irradiation of laser light, the interfacial layers of the second interfacial layer 104 and first interfacial layer 102, and moreover a part of the first wiring layer 103 are sublimated, that is, vaporized or fumed and removed. Accordingly the clean exposed face 1031 of the first wiring layer 103 is exposed at the blockage part 1061 after the irradiation of the laser light as indicated in Fig. 6. Besides, the exposed face 1031 is turned rough subsequent to the irradiation of the laser light.

Thereafter, in Fig. 2, a second wiring layer 105 of a conductor of metal or the like, specificaily of copper in the embodiment is formed to a thickness of about 15µm on the second face 101b of the insulator 101, blind via hole part 106, and blockage part 1061 by sputtering and plating. An unnecessary part is removed by etching or the like means, whereby the second wiring layer 105 of a predetermined pattern is formed. The thus-formed second wiring layer 105 lies on the exposed face 1031 at the blockage part 1061, and therefore is directly united and electrically connected to the first wiring layer 103. None of the interfacial layers 104, 102, and foreign matter 107, etc. are present at an interface of the first wiring layer 103 and second wiring layer 105. Moreover, the first wiring layer 103 and second wiring layer 105 of the same material are united. A reliability on electric connection between the first wiring layer 103 and second wiring layer 105 is thus improved in comparison with the related art.

In addition, since the exposed face 1031 of the first wiring layer 103 is made rough by the laser light as described hereinabove, a contact area between the first wiring layer. 103 and second wiring layer 105 increases, which contributes to further tight uniting of the layers.

The formation of the first interfacial layer 102, second interfacial layer 104, first wiring layer 103, and second wiring layer 105 to the insulator 101 can be carried out by various known methods such as a dry method, a wet method or the like.

The irradiation of the laser light will be more fully described hereinbelow.

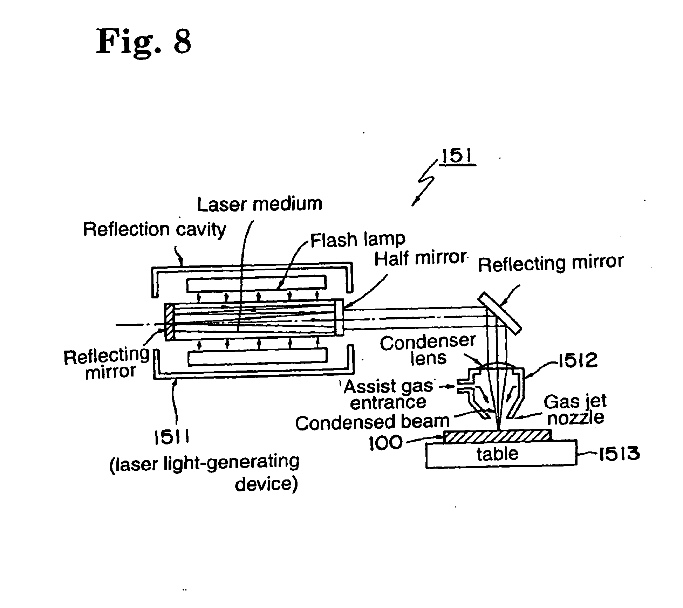

The laser apparatus 151 is a generally commercially available apparatus. As illustrated in Fig. 8, the laser light generated at a laser light-generating device 1511 is irradiated to the double-sided wiring board 100 on a table 1513 through a condenser lens part 1512. The table 1513 loading the double-sided wiring board 100 moves while being controlled in movement amount in X, Y directions orthogonal to each other so that the laser light scans the blockage part 1061. Also, it may be constructed that the table is moved, for example, only in the Y direction while the laser device is moved in the X direction.

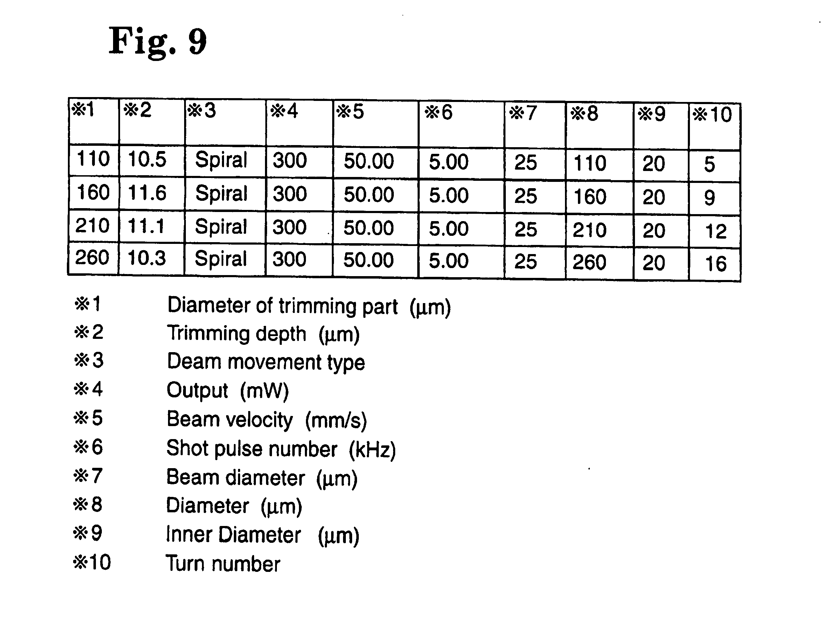

The laser light used in the embodiment is a type excited by an ark lamp or high-output diode, generated from an Nd:YAG element with a wavelength of 355nm. An example of a relationship of an irradiation condition of the laser light and a diameter of the blockage part 1061 obtained from the applicant's experiment is indicated in Fig. 9. In Fig. 9 an item of "diameter of trimming part" corresponds to the diameter of the blockage part 1061 and, an item of "trimming depth" corresponds to a thickness of the interfacial layers or the like to be removed. An item of "beam movement type" is a movement fashion of a laser beam of the laser when removing the interfacial layers or the like at the blockage part 1061. An item of "spiral" shows a spiral-shaped movement of the laser beam. An item of "output" corresponds to an intensity of the laser light. An item of "beam velocity" is a velocity of the laser beam moved to the blockage part 1061. An item of "shot pulse number" is the number of pulses because the laser light is irradiated in a form of pulses. An item of "beam diameter" is a diameter of the laser light at the interfacial layers of the blockage part 1061 or the like. According to the present embodiment, the laser light is irradiated in a manner to be focused on an object to be removed such as the interfacial layers or the like. An item of "diameter" indicates a range of the scanned laser light. Since the laser beam is scanned spirally as described above, the irradiation range is expressed by the diameter in Fig. 9. An item of "inner diameter" is a size of an inner circumferential part of the spiral and, an item of "turn number" is the number of turns with which the laser light turns spirally in the irradiation range.

The above irradiation condition is an example. The irradiation condition can be set to remove the interfacial layers 104, 102 and foreign matter 107 and expose the exposed face 1031 to the first wiring layer 103. As in the present embodiment, when the second interfacial layer 104 and first interfacial layer 102 at the blockage part 1061 and further the conductor such as the first wiring layer 103 are to be removed, the irradiation condition is set to a level such that the conductor, for instance, metal, particularly copper is sublimated. From a viewpoint of a thickness of the material to be removed, the irradiation condition is set to a level such that a material having a thickness of the material to be removed is removed, that is, a level such that the conductor having approximately 10-15µm thickness is removed, since the thickness of the material to be removed is approximately 10-15µm in the case of the embodiment.

In removing the conductor, e.g., metal, particularly copper as above, since a reflectance of the laser light decreases suddenly thereby making a trimming process possible when the wavelength of the laser light is 500nm or shorter, the wavelength of not larger than 400nm or so is particularly effective according to the experiment. Now that the laser apparatus practicable as of present generates the laser light of roughly 150-400nm wavelength, the wavelength is preferably approximately 260-355nm in the embodiment.

According to the above embodiment, the first interfacial layer 102 and second interfacial layer 104 are formed to the first face 101 a and second face 101b of the insulator 101 respectively. As a result, at least the second interfacial layer 104 and first interfacial layer 102 at the blockage part 1061 are sublimated through the irradiation of the laser light to the blockage part 1061. However, since the first wiring layer 103 can be formed directly to the first face 101 a of the insulator 101. Thus, in this case alike, the laser light can be irradiated to the first wiring layer 103 of the blockage part 1061, whereby impurities and foreign matter such as an oxide film or the like possibly formed on the first wiring layer 103 can be removed and the first wiring layer can be turned to a rough face. As a result, the exposed face 1031 is formed to the first wiring layer 103.

In the meantime, another arrangement is conceivable in which the first wiring layer 103 is directly formed on the first face 101a of the insulator 101 and, the second interfacial layer 104 is formed to the second face 101b. The laser light can be irradiated to the blockage part 1061 also in this case, and at least the second interfacial layer 104 formed on the first wiring layer 103 can be removed, namely, sublimated by the irradiation of the laser light to the blockage part 1061. The foreign matter 107 or the like mixed between the first wiring layer 103 and second interfacial layer 104 is hence removed and the exposed face 103 is formed on the first wiring layer 103.

In the double-sided wiring board 100 of the embodiment and a conventional double-sided wiring board not subjected to the laser irradiation, peeling off of the blind via hole part 106 is evaluated in a thermal shock test and a pressure cooker test. Fracture forms are confirmed after the second wiring layer 105 is peeled off from the blind via hole part 106 while the first wiring layer 103 is held. The thermal shock test is carried out according to a condition C of a MIL-STD-883. More specifically, as regulated by the MIL standards, in a state that one heat cycle lasts five minutes at 150°C at a high-temperature side and five minutes at -65°C at a low-temperature side, the blind via hole part is tested up to 1000 cycles. In this case, a high-temperature layer uses Fluorinert™ FC-43 available from 3M Company of St. Paul, MN, USA; and a low-temperature layer uses Fluorinert™ FC-77 from 3M Company. As a result, the conventional product shows an exfoliation at an interface between a first wiring layer corresponding to the first wiring layer 103 and a second wiring layer corresponding to the second wiring layer 105 already in an initial stage not reaching 250 cycles. In contrast, the double-sided wiring board 100 of the present embodiment generates no exfoliation at an interfacial part between the first and second wiring layers 103 and 105 even after 1000 cycles and the second wiring layer 105 itself breaks.

The pressure cooker test is executed under a condition of 127°C with 100% humidity up to 100 hours. The result is that the conventional product brings about an exfoliation at the interface between the first wiring layer and second wiring layer in the initial stage. On the other hand, the double-sided wiring board 100 of the embodiment generates no exfoliation at the interfacial part of the first wiring layer 103 and second wiring layer 105 even after 100 hours, while the second wiring layer 105 itself breaks.

As is clear from the above results, the interfacial part between the first wiring layer 103 and second wiring layer 105 are resistant to separation in the double-sided wiring board 100 of the embodiment. The tests prove that the first wiring layer 103 and the second wiring layer 105 are more tightly united than in the related art, thus improved in reliability on electric connection therebetween.

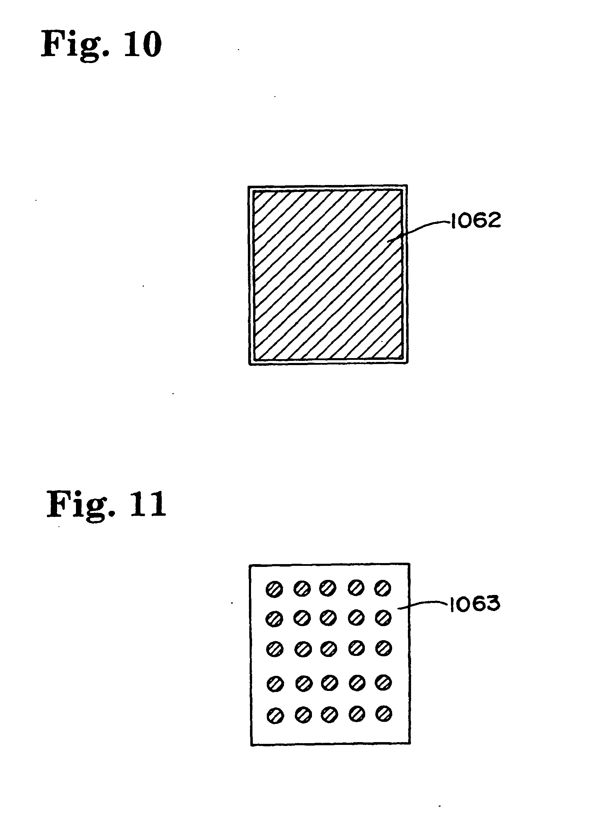

The foregoing description is related to the case where the laser light is irradiated to the blockage part 1061 of approximately 100-300µm diameter. A shape and a size of the blockage part 1061 are not limited to the above. The blockage part can be a rectangular one, for instance, 1.85mm x 2.25mm as shown in Figs. 10 and 11 in a double-sided wiring board having a recess blocked at a side of a first face and opened to a second face of an insulator having the first and second opposite faces. A blockage part 1062 in Fig. 10 and a blockage part 1063 in Fig. 11 are blocked at least by the first wiring layer 103. In the case of such wide blockage part, the exposed face 1031 by the irradiation of the laser light can be formed in a manner, for example, as follows. Specifically, the laser beam is moved in a right-left direction, not spirally, whereby the exposed face 1031 can be formed on the first wiring layer 103 in an almost entire area of the blockage part 1062 as indicated by oblique lines in Fig. 10. Or the laser beam is moved spirally for the blockage part 1063 of Fig. 11, whereby the exposed face 1031 of a plurality of, e.g., 25 circles of 150µm diameter can be formed. The method of forming the circular exposed faces 1031 at a plurality of points as above is advantageously short in process time in comparison with the case where the laser beam is moved right and left as in Fig. 10. According to the experiment, 20 seconds is required in Fig. 10, whereas the method of Fig. 11 takes only 1.3 seconds.

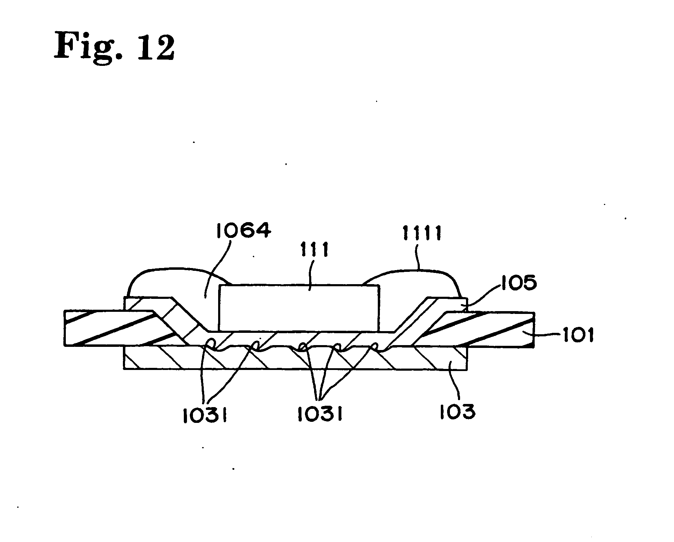

Fig. 12 illustrates an applied example of the double-sided wiring board in which the first wiring layer 103 and second wiring layer 105 are united in the method discussed with reference to Fig. 11. More specifically, the second wiring layer 105 is formed to the second face 101b and a recess 1064 of the insulator 101 after the formation of the exposed face 1031 of the first wiring layer 103. A semiconductor chip 111 is mounted to the recess 1064, and is electrically connected with the second wiring layer 105 by wires 1111, whereby a mounted substrate is obtained. The first wiring layer 103 and second wiring layer 105 are tightly connected by the exposed face 1031 in the mounted substrate as well, so that the electric connection reliability is improved more than in the related art.

Although the laser beam is spiraly moved to form the exposed face 1031 in the above embodiment, the interfacial layers 102, 104, and the first wiring layer 103 may be left without being cut at a central part of the spiral, with a projecting part remaining behind. For avoiding this, the laser beam is moved spirally in a first irradiation step and the laser light is irradiated to the remaining part in a second irradiation step. That is, the irradiation can be carried out in two steps.

As is fully described hereinabove, according to the double-sided wiring board in the first aspect of the present invention and the method for manufacturing the double-sided wiring board in the second and third aspects of the present invention, the first conductive layer is provided which has the exposed face formed by the irradiation of the laser light, and the second wiring layer is formed so as to unite and electrically connect to the exposed face. Therefore, the first conductive layer and second wiring layer are more tightly connected through the uniting at the exposed face than in the related art, the electric connection reliability between the wiring layers is improved as compared with the related art.

When the first conductive layer is the first wiring layer, the foreign matter such as the oxide film or the like formed on the first wiring layer can be eliminated by the laser light and at the same time the exposed face can be formed.

When the first conductive layer is constituted of the first interfacial layer and the first wiring layer, the first interfacial layer and second interfacial layer formed on the first wiring layer can be removed by the laser light and the exposed face can be obtained.

When the laser light has a wavelength of 400-150nm, the metal, particularly copper constituting the first conductive layer and second interfacial layer can be removed effectively.

### REFERENCE NUMBERS

100... double-sided wiring board 101 1... insulator,
101a ... first face 101b... second face,
102 ... first interfacial layer 103 ... first wiring layer,
104 ... second interfacial layer,
105 ... second wiring layer 106 blind via hole part,
1031 ... exposed face 1061 ... blockage part,
1064 ... recess.

## Claims

1. A method for manufacturing a double-sided wiring board **characterized by** comprising
- forming a first interfacial layer (102) onto a first face (101a) of an insulator (101) having the first face (101a) and a second face (101b) opposite to the first face (101a),
- forming a first wiring layer (103) of a conductor on the first interfacial layer (102),
- forming a recess (106) in the insulator (101) opened to the second face (101b), wherein a first conductive layer (108) constituting the first interfacial layer (102) and the first wiring layer (103) is used as a blockage material,
- forming a second interfacial layer (104) onto the second face (101b), the recess (106), and the first interfacial layer (102) at a blockage part (1061) of the recess (106),
- irradiating a laser light from the side of the second face (101b) to the blockage part (1061) of the recess (106) so as to remove the second interfacial layer (104) and first interfacial layer (102) at the blockage part (1061) to expose the first wiring layer (103), and
- forming a second wiring layer (105) of a conductor on the second interfacial layer (104) and the blockage part (1061) of the recess (106) wherein the second wiring layer (105) within the blockage part (1061) of the recess (106) being united on the first wiring layer (103) and electrically connected thereto.

2. Method according to claim 1, wherein the irradiated laser light has a wavelength of 400 - 150 nm.

3. A double-sided wiring board (100) comprising
- an insulator (101) having opposite first and second faces (101a,101b),
- a recess (106) in the insulator (101) the recess being blocked at the first face (101a) of the insulator (101) and opened to the second face (101b) of the insulator (101),
- a first wiring layer (103) consisting of a conductor and formed on the first face (101a) of the insulator (101) and exposed within a blockage part (1061) of the recess (106),
- a first interfacial layer (102) between the first face (101a) of the insulator (101) and the first wiring layer (103),
- a second interfacial layer. (104) consisting of a conductor and formed on the second face (101b) of the insulator (101) and the recess (106) except for the blockage part (1061) thereof, and
- a second wiring layer (105) formed on the second interfacial layer (104) and the blockage part (1061) of the recess (106);
- wherein the exposed portion of the first wiring layer (103) is exposed and roughened by a laser light from the side of the second face (101b) of the insulator (101) the laser light also for removing foreign material from the exposed portion of the first wiring layer (103), and
- wherein the second wiring layer (104) is united to the exposed portion of the first wiring layer (103) and electrically connected thereto.

## Patentansprüche

1. Verfahren zur Herstellung einer doppelseitigen Leiterplatte, **gekennzeichnet durch** die folgenden Schritte:
- Ausbilden einer ersten Grenzschicht (102) auf einer ersten Fläche (101a) eines Isolators (101), der eine erste Fläche (101a) und eine zweite Fläche (101b), die der ersten Fläche (101a) gegenüberliegt, aufweist,
- Ausbilden einer ersten Verdrahtungsschicht (103) aus einem Leiter auf der ersten Grenzschicht (102),
- Ausbilden einer Ausnehmung (106) in dem Isolator (101), die zur zweiten Fläche (101b) hin geöffnet ist, wobei eine erste leitfähige Schicht (108), welche die erste Grenzschicht (102) und die erste Verdrahtungsschicht (103) bildet, als ein Sperrmaterial verwendet wird,
- Ausbilden einer zweiten Grenzschicht (104) auf der zweiten Fläche (101b), der Ausnehmung (106) und der ersten Grenzschicht (102) an einem Sperrabschnitt (1061) der Ausnehmung (106),
- Aufstrahlen eines Laserlichts von der Seite der zweiten Fläche (101b) zu dem Sperrabschnitt (1061) der Ausnehmung (106), derart, dass die zweite Grenzschicht (104) und die erste Grenzschicht (102) an dem Sperrabschnitt (1061) entfernt werden, um die erste Verdrahtungsschicht (103) freizulegen, und
- Ausbilden einer zweiten Verdrahtungsschicht (105) aus einem Leiter auf der zweiten Grenzschicht (104) und dem Sperrabschnitt (1061) der Ausnehmung (106), wobei die zweite Verdrahtungsschicht (105) innerhalb des Sperrabschnitts (1061) der Ausnehmung (106) mit der ersten Verdrahtungsschicht (103) vereint und elektrisch mit ihr verbunden wird.

2. Verfahren nach Anspruch 1, wobei das aufgestrahlte Laserlicht eine Wellenlänge von 400-150 nm aufweist.

3. Doppelseitige Leiterplatte (100) mit:
- einem Isolator (101), der eine erste Fläche (101a) und eine zweite Fläche (101b) aufweist, die einander gegenüberliegen,
- einer Ausnehmung (106) in dem Isolator (101), wobei die Ausnehmung an der ersten Fläche (101a) des Isolators (101) gesperrt ist und zur zweiten Fläche (101b) des Isolators (101) hin geöffnet ist,
- einer ersten Verdrahtungsschicht (103), die aus einem Leiter besteht und auf der ersten Fläche (101a) des Isolators (101) ausgebildet ist und innerhalb eines Sperrabschnitts (1061) der Ausnehmung (106) freiliegt,
- einer ersten Grenzschicht (102) zwischen der ersten Fläche (101a) des Isolators (101) und der ersten Verdrahtungsschicht (103),
- einer zweiten Grenzschicht (104), die aus einem Leiter besteht und auf der zweiten Fläche (101b) des Isolators (101) und der Ausnehmung (106) - mit Ausnahme des Sperrabschnitts (1061) der Ausnehmung (106) - ausgebildet ist, und
- einer zweiten Verdrahtungsschicht (105), die auf der zweiten Grenzschicht (104) und dem Sperrabschnitt (1061) der Ausnehmung (106) ausgebildet ist,
- wobei der freiliegende Abschnitt der ersten Verdrahtungsschicht (103) durch ein Laserlicht von der Seite der zweiten Fläche (101b) des Isolators (101) freigelegt und aufgeraut wird, wobei das Laserlicht des Weiteren zum Entfernen von Fremdmaterial von dem freiliegenden Abschnitt der ersten Verdrahtungsschicht (103) dient, und
- wobei die zweite Verdrahtungsschicht (104) mit dem freiliegenden Abschnitt der ersten Verdrahtungsschicht (103) vereint und elektrisch mit ihr verbunden wird.

## Revendications

1. Procédé pour fabriquer une carte de circuit double face, **caractérisé en ce qu'**il comprend les étapes qui consistent à :
former une première couche d'interface (102) sur une première face (101a) d'un isolant (101) doté d'une première face (101a) et d'une deuxième face (101b) opposée à la première face (101a),
former une première couche de circuit (103) d'un conducteur sur la première couche d'interface (102),
ménager dans l'isolant (101) un creux (106) ouvert vers la deuxième face (101b), une première couche conductrice (108) constituant la première couche d'interface (102) et la première couche de circuit (103) faisant fonction de matériau de blocage,
au niveau d'une partie de blocage (1061) du creux (106), former une deuxième couche d'interface (104) sur la deuxième face (101b), le creux (106) et la première couche d'interface (102)
par le côté de la deuxième face (101b), appliquer un rayonnement laser sur la partie de blocage (1061) du creux (106) pour enlever la deuxième couche d'interface (104) et la première couche d'interface (102) au niveau de la partie de blocage (1061), de manière à exposer la première couche de circuit (103) et
sur la deuxième couche d'interface (104) et sur la partie de blocage (1061) du creux (106), former une deuxième couche de circuit (105) d'un conducteur, la deuxième couche de circuit (105) étant reliée à la première couche de circuit (103) et y étant raccordée électriquement dans la partie de blocage (1061) du creux (106).

2. Procédé selon la revendication 1, dans lequel la longueur d'onde du rayonnement laser est de 400 à 150 nm.

3. Carte de circuit double face (100) qui comprend :
un isolant (101) doté d'une première face et d'une deuxième face opposées (101a, 101b),
un creux (106) ménagé dans l'isolant (101), le creux étant bloqué sur la première face (101a) de l'isolant (101) et étant ouvert sur la deuxième face (101b) de l'isolant (101),
une première couche de circuit (103) constituée d'un conducteur, formée sur la première face (101a) de l'isolant (101) et exposée dans une partie de blocage (1061) du creux (106),
une première couche d'interface (102) située entre la première face (101a) de l'isolant (101) et la première couche de circuit (103),
une deuxième couche d'interface (104) constituée d'un conducteur et formée sur la deuxième face (101b) de l'isolant (101) et sur le creux (106) mais pas sur sa partie de blocage (1061) et
une deuxième couche de circuit (105) formée sur la deuxième couche d'interface (104) et sur la partie de blocage (1061) du creux (106),
la partie exposée de la première couche de circuit (103) étant exposée et rendue rugueuse en appliquant un rayonnement laser par le côté de la deuxième face (101b) de l'isolant (101), le rayonnement laser étant également destiné à enlever la matière étrangère de la partie exposée de la première couche de circuit (103), et
la deuxième couche de circuit (104) étant reliée à la partie exposée de la première couche de circuit (103) et y étant raccordée électriquement.
